# EUROPEAN PATENT APPLICATION

(11) **EP 4 614 757 A1**
(43) Date of publication of application: **10.09.2025**
(21) Application number: 23926122.5
(22) Date of filing: 28.12.2023
(51) Int. Cl.: H02J 7/00

(54) **ENERGY STORAGE SYSTEM AND LEAKAGE FAULT LOCATING METHOD THEREFOR**

(30) Priority: 09.03.2023 CN 202310271679
(71) Applicant: Huawei Digital Power Technologies Co., Ltd., Shenzhen, Guangdong 518043 (CN)
(72) Inventor: SHENG, Ren, Shenzhen, Guangdong 518043 (CN); WU, Yihong, Shenzhen, Guangdong 518043 (CN); LI, Kaiyan, Shenzhen, Guangdong 518043 (CN); CHEN, Baoguo, Shenzhen, Guangdong 518043 (CN)
(74) Representative: Maiwald GmbH
(86) International application number: PCT/CN2023/142962
(87) International publication number: WO 2024/183428

(57) **Abstract**

This application provides an energy storage system and a leakage current fault location method thereof. **In** the energy storage system, a battery cluster is connected to one end of a battery cluster control circuit, the other end of the battery cluster control circuit is connected to one end of a first power conversion circuit, the other end of the first power conversion circuit is configured to connect to a power grid or a load, and a first detection circuit is disposed between the first power conversion circuit and the power grid or the load. When the first detection circuit detects that a leakage current of the energy storage system is greater than a preset safety threshold, a controller controls the battery cluster control circuit and the first power conversion circuit to be disconnected. **In** addition, after controlling the battery cluster control circuit and the first power conversion circuit to be disconnected, the controller controls the battery cluster control circuit to be connected, and sends, based on that the first detection circuit detects that the leakage current of the energy storage system is greater than the preset safety threshold, alarm information indicating that a leakage current fault occurs in the battery cluster. According to this application, a location at which the leakage current fault occurs in the energy storage system can be determined, thereby facilitating system maintenance.

## Description

This application claims priority to Chinese Patent Application No. 202310271679.7, filed with the China National Intellectual Property Administration on March 9, 2023 and entitled "ENERGY STORAGE SYSTEM AND LEAKAGE CURRENT FAULT LOCATION METHOD THEREOF", which is incorporated herein by reference in its entirety.

### TECHNICAL FIELD

This application relates to the field of energy storage technologies, and in particular, to an energy storage system and a leakage current fault location method thereof.

### BACKGROUND

A leakage current fault that occurs in a battery cluster, a cable, or a functional module circuit in an energy storage system causes a large leakage current of the energy storage system to the ground, resulting in a safety accident. Therefore, in an existing energy storage system, if a leakage current fault occurs in a location in the energy storage system, the energy storage system generates a protection action, in other words, disconnects power module circuits from each other in the energy storage system. Then, the leakage current fault in the energy storage system is manually checked. This makes system maintenance difficult.

### SUMMARY

This application provides an energy storage system and a leakage current fault location method thereof, to determine a location at which a leakage current fault occurs in the energy storage system, thereby facilitating system maintenance.

According to a first aspect, this application provides an energy storage system. The energy storage system includes a battery cluster, a battery cluster control circuit, a first power conversion circuit, a first detection circuit, and a controller.

A specific connection relationship of the energy storage system is: The battery cluster is connected to one end of the battery cluster control circuit, the other end of the battery cluster control circuit is connected to one end of the first power conversion circuit, the other end of the first power conversion circuit is configured to connect to a power grid or a load, and the first detection circuit is disposed between the first power conversion circuit and the power grid or the load.

During specific implementation, when the first detection circuit detects that a leakage current of the energy storage system is greater than a preset safety threshold, the controller controls the battery cluster control circuit and the first power conversion circuit to be disconnected. After controlling the battery cluster control circuit and the first power conversion circuit to be disconnected, the controller controls the battery cluster control circuit to be connected, and sends, based on that the first detection circuit detects that the leakage current of the energy storage system is greater than the preset safety threshold, alarm information indicating that a leakage current fault occurs in the battery cluster.

In embodiments of this application, after the leakage current fault occurs in the energy storage system, after enabling the battery cluster control circuit and the first power conversion circuit to be disconnected, the controller further enables the battery cluster control circuit to be connected, and detects the leakage current of the energy storage system, so that a case in which the leakage current fault that is caused by the battery cluster and that occurs in the energy storage system can be checked out. In other words, it is determined that the leakage current fault occurs in the battery cluster in the energy storage system, and the battery cluster can be directly repaired or replaced. This facilitates maintenance of the energy storage system, and has high maintenance efficiency.

With reference to the first aspect, in a first possible implementation, the first power conversion circuit includes a first connection switch unit, and the first connection switch unit is configured to connect to the battery cluster control circuit.

When the battery cluster control circuit is connected, if the first detection circuit detects that the leakage current of the energy storage system is less than or equal to the preset safety threshold, the controller controls the first connection switch unit to be turned on. In this case, when the first connection switch unit is turned on, the controller sends, based on that the first detection circuit detects that the leakage current of the energy storage system is greater than the preset safety threshold, alarm information indicating that the leakage current fault occurs in a loop between the battery cluster control circuit and the first power conversion circuit.

With reference to the first possible implementation of the first aspect, in a second possible implementation, the first power conversion circuit further includes a first power switch unit, and the first power switch unit is disposed between the first connection switch unit and the first detection circuit.

When the first connection switch unit is turned on, if the first detection circuit detects that the leakage current of the energy storage system is less than or equal to the preset safety threshold, the controller controls the first power switch unit to be turned on. In this case, when the first power switch unit is turned on, the controller sends, based on that the first detection circuit detects that the leakage current of the energy storage system is greater than the preset safety threshold, alarm information indicating that the leakage current fault occurs in the first power conversion circuit.

With reference to the first possible implementation of the first aspect or the second possible implementation of the first aspect, in a third possible implementation, the first power conversion circuit further includes a second connection switch unit, and the second connection switch unit is disposed between the first power switch unit and the first detection circuit.

When the first power switch unit is turned on, if the first detection circuit detects that the leakage current of the energy storage system is less than or equal to the preset safety threshold, the controller controls the second connection switch unit to be turned on. When the second connection switch unit is turned on, the controller sends, based on that the first detection circuit detects that the leakage current of the energy storage system is greater than the preset safety threshold, alarm information indicating that the leakage current fault occurs in a loop between the first power conversion circuit and the power grid or the load.

With reference to the first possible implementation of the first aspect to the third possible implementation of the first aspect, in a fourth possible implementation, the energy storage system further includes a second power conversion circuit, and the second power conversion circuit is disposed between the battery cluster control circuit and the first connection switch unit. The power conversion circuit includes a second power switch unit, and the second power switch unit is configured to convert an input voltage or an output voltage of the battery cluster.

When the battery cluster control circuit is connected, if the first detection circuit detects that the leakage current of the energy storage system is less than or equal to the preset safety threshold, before controlling the first connection switch unit to be turned on, the controller controls the second power switch unit to be turned on. In this case, when the second power switch unit is turned on, the controller sends, based on that the first detection circuit detects that the leakage current of the energy storage system is greater than the preset safety threshold, alarm information indicating that the leakage current fault occurs in the battery cluster control circuit.

With reference to the fourth possible implementation of the first aspect, in a fifth possible implementation, the second power conversion circuit further includes a third connection switch unit, and the third connection switch unit is configured to connect to the first connection switch unit.

When the second power switch unit is turned on, if the first detection circuit detects that the leakage current of the energy storage system is less than or equal to the preset safety threshold, the controller controls the third connection switch unit to be turned on. When the third connection switch unit is turned on, the controller sends, based on that the first detection circuit detects that the leakage current of the energy storage system is greater than the preset safety threshold, alarm information indicating that the leakage current fault occurs in the second power conversion circuit.

With reference to any one of the foregoing possible implementations of the first aspect or the first aspect, in a sixth possible implementation, the energy storage system further includes a second detection circuit, and the second detection circuit is disposed between the battery cluster and the battery cluster control circuit.

When the second detection circuit detects that the leakage current of the battery cluster is greater than a battery safe current, the controller sends alarm information indicating that the leakage current fault occurs in the battery cluster. In embodiments of this application, double determining of the leakage current fault can be provided for the battery cluster, and safety is good.

With reference to the sixth possible implementation of the first aspect, in a seventh possible implementation, when no leakage current fault occurs in the battery cluster, the preset safety threshold is updated based on the leakage current of the battery cluster detected by the second detection circuit.

According to a second aspect, an embodiment of this application provides a leakage current fault location method for an energy storage system. The energy storage system includes a battery cluster, a battery cluster control circuit, a first power conversion circuit, and a first detection circuit. A specific connection relationship of the energy storage system is: The battery cluster is connected to one end of the battery cluster control circuit, the other end of the battery cluster control circuit is connected to one end of the first power conversion circuit, the other end of the first power conversion circuit is configured to connect to a power grid or a load, and the first detection circuit is disposed between the first power conversion circuit and the power grid or the load.

Specific implementation of the leakage current fault location method is: when the first detection circuit detects that a leakage current of the energy storage system is greater than a preset safety threshold, controlling the battery cluster control circuit and the first power conversion circuit to be disconnected; and after controlling the battery cluster control circuit and the first power conversion circuit to be disconnected, controlling the battery cluster control circuit to be connected, and sending, based on that the first detection circuit detects that the leakage current of the energy storage system is greater than the preset safety threshold, alarm information indicating that a leakage current fault occurs in the battery cluster.

With reference to the second aspect, in a first possible implementation, the first power conversion circuit includes a first connection switch unit, and the first connection switch unit is configured to connect to the battery cluster control circuit.

The leakage current fault location method further includes:
when the battery cluster control circuit is connected, if the first detection circuit detects that the leakage current of the energy storage system is less than or equal to the preset safety threshold, controlling the first connection switch unit to be turned on; and when the first connection switch unit is turned on, sending, based on that the first detection circuit detects that the leakage current of the energy storage system is greater than the preset safety threshold, alarm information indicating that the leakage current fault occurs in a loop between the battery cluster and the first power conversion circuit.

With reference to the first possible implementation of the second aspect, in a second possible implementation, the first power conversion circuit further includes a first power switch unit, and the first power switch unit is disposed between the first connection switch unit and the first detection circuit.

The leakage current fault location method further includes:
when the first connection switch unit is turned on, if the first detection circuit detects that the leakage current of the energy storage system is less than or equal to the preset safety threshold, controlling the first power switch unit to be turned on; and when the first power switch unit is turned on, sending, based on that the first detection circuit detects that the leakage current of the energy storage system is greater than the preset safety threshold, alarm information indicating that the leakage current fault occurs in the first power conversion circuit.

With reference to the first possible implementation of the second aspect or the second possible implementation of the second aspect, in a third possible implementation, the first power conversion circuit further includes a second connection switch unit, and the second connection switch unit is disposed between the first power switch unit and the first detection circuit.

The leakage current fault location method further includes:
when the first power switch unit is turned on, if the first detection circuit detects that the leakage current of the energy storage system is less than or equal to the preset safety threshold, controlling the second connection switch unit to be turned on; and when the second connection switch unit is turned on, sending, based on that the first detection circuit detects that the leakage current of the energy storage system is greater than the preset safety threshold, alarm information indicating that the leakage current fault occurs in a loop between the first power conversion circuit and the power grid or the load.

With reference to the first possible implementation of the second aspect to the third possible implementation of the second aspect, in a fourth possible implementation, the energy storage system further includes a second power conversion circuit, and the second power conversion circuit is disposed between the battery cluster control circuit and the first connection switch unit. The power conversion circuit further includes a second power switch unit, and the second power switch unit is configured to convert an input voltage or an output voltage of the battery cluster.

The leakage current fault location method further includes:
when the battery cluster control circuit is connected, if the first detection circuit detects that the leakage current of the energy storage system is less than or equal to the preset safety threshold, before controlling the first connection switch unit to be turned on, controlling the second power switch unit to be turned on; and when the second power switch unit is turned on, sending, based on that the first detection circuit detects that the leakage current of the energy storage system is greater than the preset safety threshold, alarm information indicating that the leakage current fault occurs in the battery cluster control circuit.

With reference to the fourth possible implementation of the second aspect, in a fifth possible implementation, the second power conversion circuit further includes a third connection switch unit, and the third connection switch unit is configured to connect to the first connection switch unit.

The leakage current fault location method further includes:
when the second power switch unit is turned on, if the first detection circuit detects that the leakage current of the energy storage system is less than or equal to the preset safety threshold, controlling the third connection switch unit to be turned on; and when the third connection switch unit is turned on, sending, based on that the first detection circuit detects that the leakage current of the energy storage system is greater than the preset safety threshold, alarm information indicating that the leakage current fault occurs in the second power conversion circuit.

With reference to any one of the foregoing possible implementations of the second aspect or the second aspect, in a sixth possible implementation, the energy storage system further includes a second detection circuit, and the second detection circuit is disposed between the battery cluster and the battery cluster control circuit.

The leakage current fault location method further includes:
when the second detection circuit detects that the leakage current of the battery cluster is greater than a battery safe current, sending alarm information indicating that the leakage current fault occurs in the battery cluster.

With reference to the sixth possible implementation of the second aspect, in a seventh possible implementation, the leakage current fault location method further includes:
when no leakage current fault occurs in the battery cluster, updating the preset safety threshold based on the leakage current of the battery cluster detected by the second detection circuit.

It should be understood that implementation and beneficial effect of the foregoing aspects of this application may be referred to each other.

### BRIEF DESCRIPTION OF DRAWINGS

FIG. 1 is a block diagram of a structure of an energy storage system according to an embodiment of this application;
FIG. 2 is a schematic flowchart of a leakage current fault location method for an energy storage system according to an embodiment of this application;
FIG. 3 is a block diagram of a structure of a first power conversion circuit according to an embodiment of this application;
FIG. 4 is another schematic flowchart of a leakage current fault location method for an energy storage system according to an embodiment of this application;
FIG. 5 is a block diagram of another structure of an energy storage system according to an embodiment of this application;
FIG. 6 is a block diagram of still another structure of an energy storage system according to an embodiment of this application;
FIG. 7 is a block diagram of a structure of a second power conversion circuit according to an embodiment of this application; and
FIG. 8A and FIG. 8B are still another schematic flowchart of a leakage current fault location method for an energy storage system according to an embodiment of this application.

### DESCRIPTION OF EMBODIMENTS

The following clearly and completely describes the technical solutions in embodiments of this application with reference to the accompanying drawings in embodiments of this application. It is clearly that the described embodiments are some but not all of embodiments of this application. All other embodiments obtained by a person of ordinary skill in the art based on embodiments of this application without creative efforts shall fall within the protection scope of this application.

The following further describes implementations of the technical solutions of this application in detail with reference to the accompanying drawings.

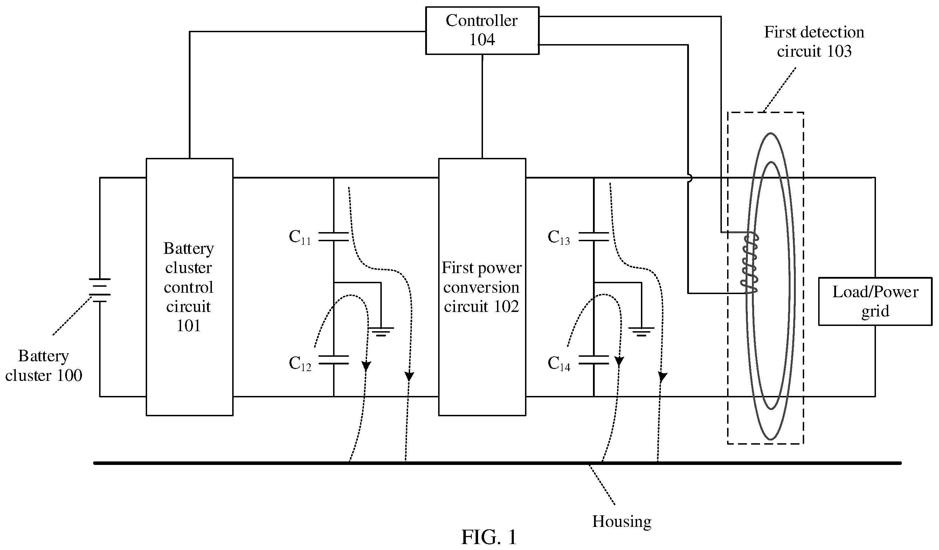

FIG. 1 is a block diagram of a structure of an energy storage system according to an embodiment of this application. As shown in FIG. 1, the energy storage system includes a battery cluster 100, a battery cluster control circuit 101, a first power conversion circuit 102, a first detection circuit 103, and a controller 104.

The battery cluster 100 is connected to one end of the battery cluster control circuit 101. For example, the battery cluster 100 may include one battery pack, or include a plurality of battery packs in a series, parallel, or series-parallel connection relationship. The battery cluster control circuit 101 may manage the battery cluster 100, and may generally be disposed in a high-voltage control box of the battery cluster 100. For example, the battery cluster control circuit 101 may collect a voltage and a current of the battery cluster 100, collect voltage and temperature information of the battery packs in the battery cluster 100, and calculate a state of charge of the battery cluster 100. Optionally, the battery cluster control circuit 101 may have a CAN communication interface, to implement a data communication function with another functional circuit. Alternatively, the battery cluster control circuit 101 may further have an RS-485 communication interface or an Ethernet communication interface, to implement communication with an external device. It should be noted that for specific implementation of the battery cluster control circuit 101, refer to the conventional technology. The battery cluster control circuit 101 is not limited in embodiments of this application.

The other end of the battery cluster control circuit 101 is connected to one end of the first power conversion circuit 102, and the other end of the first power conversion circuit 102 may be connected to a power grid or a load. For example, the first power conversion circuit 102 may be implemented as a power conversion system (power conversion system, PCS), a DC/DC converter, an AC/DC converter, or a DC/AC converter. Specific implementation of the first power conversion circuit 102 may be adjusted by using a component connected to the other end of the first power conversion circuit 102. For example, if the first power conversion circuit 102 is connected to the power grid, the first power conversion circuit 102 may be implemented as the DC/AC converter. In this case, the first power conversion circuit 102 may convert a direct current output by the battery cluster 100 into an alternating current, and connect the alternating current to the power grid. Alternatively, the first power conversion circuit 102 may be implemented as the PCS. In this case, in addition to converting a direct current output by the battery cluster 100 into an alternating current, and connecting the alternating current to the power grid, the first power conversion circuit 102 may further convert an alternating current provided by the power grid into a direct current to charge the battery cluster 100. For another example, the first power conversion circuit 102 is connected to the load, and the load is specifically implemented as a direct current load. In this case, the first power conversion circuit 102 may be implemented as the DC/DC converter, may convert a direct current output by the battery cluster 100, and provide the converted direct current for the direct current load.

The first detection circuit 103 is disposed between the first power conversion circuit 102 and the power grid or the load. For example, the first detection circuit 103 is a leakage current protection apparatus in the energy storage system, and may be specifically implemented as a residual current device (residual current device, RCD).

The controller 104 is connected to the battery cluster control circuit 101, the first power conversion circuit 102, and the first detection circuit 103. During specific implementation, the controller 104 may be specifically implemented as a micro control unit (micro control unit, MCU), a central processing unit (central processing unit, CPU), another general purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like.

In some feasible implementations, the energy storage system further includes Y capacitors. The Y capacitors are capacitors that separately span two power lines and the ground, and generally appear in a pair, for example, a capacitor *C*₁₁ and a capacitor *C*₁₂ shown in FIG. 1. A leakage current of the energy storage system specifically refers to a current between the two power lines and the ground. For example, one power line passes through the capacitor *C*₁₁ to form a loop to the ground, and a ground of the energy storage system is connected to the ground through a housing of a cabinet. Similarly, another power line may also pass through the capacitor *C*₁₂ to form a loop to the ground. Therefore, the leakage current of the energy storage system to the ground may be considered as a current between the power line and the housing. Optionally, the energy storage system may include a plurality of pairs of Y capacitors, for example, a capacitor *C*₁₃ and a capacitor *C*₁₄ shown in FIG. 1.

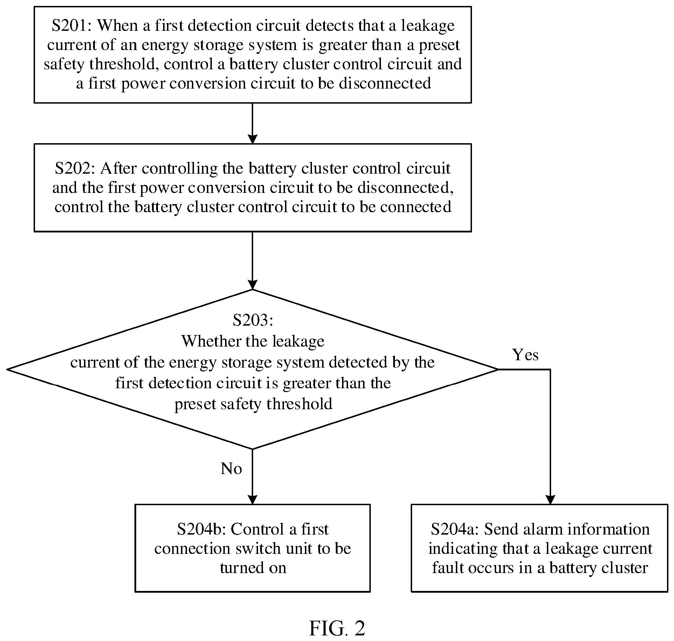

In embodiments of this application, the controller 104 may perform a leakage current fault location method shown in FIG. 2, to locate a leakage current fault in the energy storage system. Specific execution steps are as follows.

S201: When the first detection circuit 103 detects that a leakage current of the energy storage system is greater than a preset safety threshold, the controller 104 may control the battery cluster control circuit 101 and the first power conversion circuit 102 to be disconnected.

During specific implementation, the first detection circuit 103 may detect a current phasor sum between two power lines by using a current transformer, to obtain the leakage current of the energy storage system. In this case, the current transformer in the first detection circuit 103 spans the two power lines. For a specific implementation principle, refer to a conventional RCD. Details are not described herein again.

When the first detection circuit 103 detects that the leakage current of the energy storage system is greater than the preset safety threshold, the controller 104 determines that the leakage current fault occurs in the energy storage system, and the controller 104 protects the energy storage system, in other words, controls the battery cluster control circuit 101 and the first power conversion circuit 102 to be disconnected.

A value of the preset safety threshold may be preset, and the preset safety threshold is related to a stage quantity set in the energy storage system and a leakage current existing in normal running of the energy storage system. For example, the stage quantity set in the energy storage system may be understood as: The battery cluster 100 is of one stage, the battery cluster control circuit 101 is of one stage, and the first power conversion circuit 102 is of one stage. In this case, the stage quantity of the energy storage system shown in FIG. 1 is 3. The conventional technology has the following disadvantages, through measurement and observation, that the leakage current existing in the normal running of the energy storage system is 0.5 A, or the inventor of this application learns, through theoretical calculation, that the leakage current existing in the normal running of the energy storage system is 0.5 A. In addition, in research and practice, the inventor of this application sets an amplification coefficient correspondingly based on the stage quantity of the energy storage system. For example, an amplification coefficient corresponding to the stage quantity 3 is 5. In this case, the controller 104 stores the leakage current existing in the normal running of the energy storage system and the amplification coefficient corresponding to the stage quantity of the energy storage system. The controller 104 multiplies the leakage current existing in the normal running of the energy storage system by the amplification coefficient, to obtain the preset safety threshold. For example, the preset safety threshold is 0.5A × 5 = 2.5A.

Optionally, in different energy storage systems, stage quantities of the energy storage systems and leakage currents existing in normal running of the energy storage systems are different, and values of preset safety thresholds may be different.

S202: After controlling the battery cluster control circuit 101 and the first power conversion circuit 102 to be disconnected, the controller 104 controls the battery cluster control circuit 101 to be connected.

S203: The controller 104 determines whether the leakage current of the energy storage system detected by the first detection circuit 103 is greater than the preset safety threshold. In this case, the battery cluster control circuit 101 is connected. If the first detection circuit 103 detects that the leakage current of the energy storage system is greater than the preset safety threshold, the controller 104 performs step S204a. Otherwise, the controller 104 performs step S204b.

S204a: The controller 104 sends alarm information indicating that the leakage current fault occurs in the battery cluster 100. In this case, the battery cluster control circuit 101 is in an on state, and the first detection circuit 103 detects that the leakage current of the energy storage system is greater than the preset safety threshold. It may be considered that the leakage current of the energy storage system is caused by the battery cluster 100. The controller 104 determines that the leakage current fault occurs in the battery cluster 100, and sends the alarm information indicating that the leakage current fault occurs in the battery cluster 100. Optionally, a display apparatus is disposed in the energy storage system, and the controller 104 sends, to the display apparatus, the alarm information indicating that the leakage current fault occurs in the battery cluster 100. For example, the controller 104 sends "1" to the display apparatus, where "1" indicates that the leakage current fault occurs in the battery cluster 100. Further, the display apparatus displays "1", indicating that the leakage current fault occurs in the battery cluster 100. Alternatively, the controller 104 may send, to a cloud server, the alarm information indicating that the leakage current fault occurs in the battery cluster 100. The cloud server is configured to manage a plurality of energy storage systems. The cloud server may mark and process the leakage current fault in the battery cluster 100.

In embodiments of this application, after the leakage current fault occurs in the energy storage system, after enabling the battery cluster control circuit and the first power conversion circuit to be disconnected, the controller further enables the battery cluster control circuit to be connected, and detects the leakage current of the energy storage system, so that a case in which the leakage current fault that is caused by the battery cluster and that occurs in the energy storage system can be checked out. In other words, it is determined that the leakage current fault occurs in the battery cluster in the energy storage system, and the alarm information indicating that the leakage current fault occurs in the battery cluster is sent, so that maintenance personnel can directly locate the fault in the energy storage system, and repair or replace the battery cluster. This facilitates maintenance of the energy storage system, and has high maintenance efficiency.

S204b: The controller 104 controls a first connection switch unit to be turned on. In this case, the battery cluster control circuit 101 is in the on state, and the first detection circuit 103 detects that the leakage current of the energy storage system is less than or equal to the preset safety threshold. It may be considered that no leakage current fault occurs in the battery cluster 100, and the controller 104 further controls the first connection switch unit to be turned on.

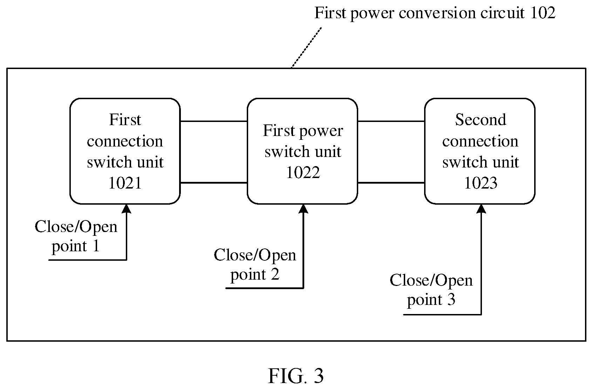

The first connection switch unit is a part of the first power conversion circuit 102. During specific implementation, a structure of the first power conversion circuit 102 is shown in FIG. 3. To be specific, the first power conversion circuit 102 includes the first connection switch unit 1021, a first power switch unit 1022, and a second connection switch unit 1023. The first connection switch unit 1021 is connected to the battery cluster control circuit 101, the first power switch unit 1022 is disposed between the first connection switch unit 1021 and the first detection circuit 103, and the second connection switch unit 1023 is disposed between the first power switch unit 1022 and the first detection circuit 103. In other words, one end of the first connection switch unit 1021 is connected to the battery cluster control circuit 101, the other end of the first connection switch unit 1021 is connected to one end of the first power switch unit 1022, the other end of the first power switch unit 1022 is connected to one end of the second connection switch unit 1023, and the other end of the second connection switch unit 1023 is connected to a load or a power grid.

In some feasible implementations, at least one of the first connection switch unit 1021, the first power switch unit 1022, and the second connection switch unit 1023 may be specifically implemented as a solid-state switch, for example, a contactor or a relay. Alternatively, at least one of the first connection switch unit 1021, the first power switch unit 1022, and the second connection switch unit 1023 may be specifically implemented as a semiconductor switch, for example, a metal-oxide-semiconductor field-effect transistor (metal-oxide-semiconductor field-effect transistor, MOSFET) or an insulated gate bipolar transistor (insulated gate bipolar transistor, IGBT).

In step S201, the controller 104 controls the first power conversion circuit 102 to be disconnected, that is, controls the first connection switch unit 1021, the first power switch unit 1022, and the second connection switch unit 1023 to be turned off, in other words, opens a close/open point 1, a close/open point 2, and a close/open point 3. It may be understood that the close/open point 1, the close/open point 2, and the close/open point 3 may be considered as locations, of the switch units, that may be controlled by the controller 104. For example, the controller 104 opens the close/open point 1, in other words, disconnects the first connection switch unit 1021 from the battery cluster control circuit 101 and the first power conversion circuit 1022. The controller 104 opens the close/open point 2, in other words, disconnects the first power switch unit 1022 from the first connection switch unit 1021 and the second connection switch unit 1023. The controller 104 opens the close/open point 3, in other words, disconnects the second connection switch unit 1023 from the first power switch unit 1022 and the power grid or the load.

After the controller 104 performs step S202, when the first detection circuit 103 detects that the leakage current of the energy storage system is less than or equal to the preset safety threshold, the controller 104 controls the first connection switch unit 1021 to be turned on, that is, controls the close/open point 1 to be closed, and connects the first connection switch unit 1021 to the battery cluster control circuit 101. In this case, the first power switch unit 1022 and the second connection switch unit 1023 are still in an off state.

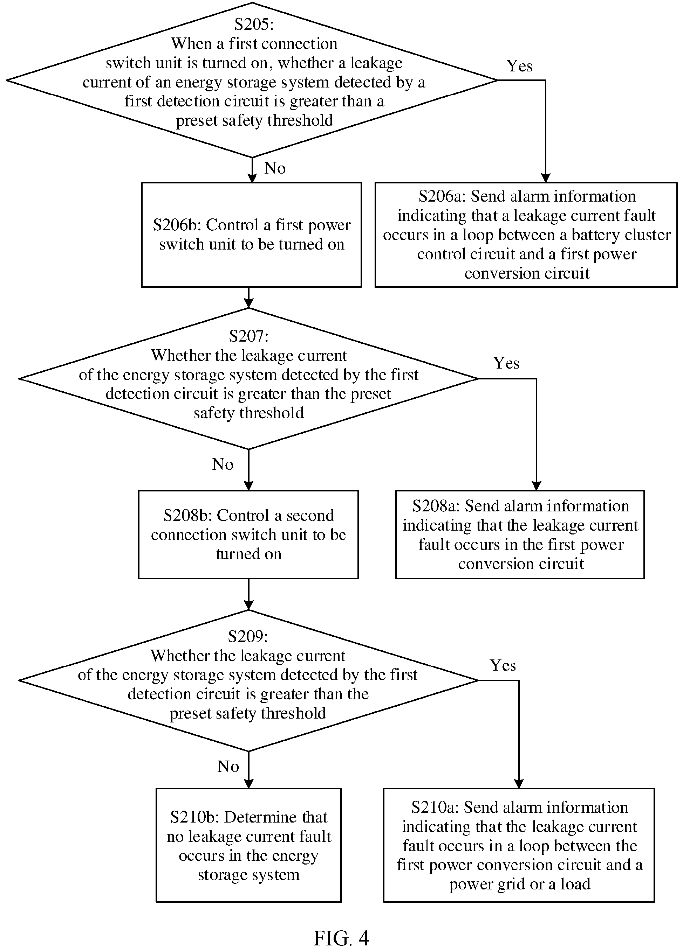

In this case, the controller may continue to perform the leakage current fault location method shown in FIG. 4, where specific execution steps are as follows.

S205: When the first connection switch unit 1021 is turned on, the controller 104 determines whether the leakage current of the energy storage system detected by the first detection circuit 103 is greater than the preset safety threshold. In this case, the battery cluster control circuit 101 and the first connection switch unit 1021 are in the on state. If the first detection circuit 103 detects that the leakage current of the energy storage system is greater than the preset safety threshold, the controller 104 performs step S206a. Otherwise, the controller 104 performs step S206b.

S206a: The controller 104 sends alarm information indicating that the leakage current fault occurs in a loop between the battery cluster control circuit 101 and the first power conversion circuit 102. During specific implementation, after performing step S204b, the controller 104 further controls the first connection switch unit 1021 to be turned on. In other words, the controller 104 eliminates a possibility that the leakage current fault occurs in the battery cluster 100, and further controls the first connection switch unit 1021 to be turned on. In this case, the first detection circuit 103 detects that the leakage current of the energy storage system is greater than the preset safety threshold, and it may be considered that the leakage current of the energy storage system is caused by the loop between the battery cluster control circuit 101 and the first power conversion circuit 102. In other words, it is determined that the leakage current fault occurs in the loop between the battery cluster control circuit 101 and the first power conversion circuit 102. For example, that the leakage current fault occurs in the loop between the battery cluster control circuit 101 and the first power conversion circuit 102 may be that the leakage current fault occurs in a cable connecting the battery cluster control circuit 101 to the first power conversion circuit 102, or that the leakage current fault occurs in a contactor or a relay between the battery cluster control circuit 101 and the first power conversion circuit 102. In this case, when determining that the leakage current fault occurs in the loop between the battery cluster control circuit 101 and the first power conversion circuit 102, the controller 104 sends the alarm information indicating that the leakage current fault occurs in the loop between the battery cluster control circuit and the first power conversion circuit. Optionally, the controller 104 sends, to the display apparatus, the alarm information indicating that the leakage current fault occurs in the loop between the battery cluster control circuit and the first power conversion circuit. For example, the controller 104 sends 2 to the display apparatus, where 2 indicates that the leakage current fault occurs in the loop between the battery cluster control circuit 101 and the first power conversion circuit 102. Alternatively, the controller 104 may send, to the cloud server, the alarm information indicating that the leakage current fault occurs in the loop between the battery cluster control circuit and the first power conversion circuit, and the cloud server may mark and process a case in which the leakage current fault occurs in the loop between the battery cluster control circuit and the first power conversion circuit.

S206b: The controller 104 controls the first power switch unit 1022 to be turned on. In this case, the battery cluster control circuit 101 and the first connection switch unit 1021 are in the on state, and the first detection circuit 103 detects that the leakage current of the energy storage system is less than or equal to the preset safety threshold. It may be considered that no leakage current fault occurs in the battery cluster 100 and in the loop between the battery cluster control circuit 101 and the first power conversion circuit 102, and the controller 104 further controls the first power switch unit 1022 to be turned on.

S207: The controller 104 determines whether the leakage current of the energy storage system detected by the first detection circuit 103 is greater than the preset safety threshold. In this case, the battery cluster control circuit 101, the first connection switch unit 1021, and the first power switch unit 1022 are in the on state. If the first detection circuit 103 detects that the leakage current of the energy storage system is greater than the preset safety threshold, the controller 104 performs step S208a. Otherwise, the controller 104 performs step S208b.

S208a: The controller 104 sends alarm information indicating that the leakage current fault occurs in the first power conversion circuit 102. During specific implementation, because after performing step S206b, that is, the controller 104 eliminates a possibility that the leakage current fault occurs in the battery cluster 100 and in the loop between the battery cluster control circuit 101 and the first power conversion circuit 102, the controller 104 further controls the first power switch unit 1022 to be turned on. In this case, the first detection circuit 103 detects that the leakage current of the energy storage system is greater than the preset safety threshold, and it may be considered that the leakage current of the energy storage system is caused by the first power conversion circuit 102. The controller 104 determines that the leakage current fault occurs in the first power conversion circuit 102, and sends the alarm information indicating that the leakage current fault occurs in the first power conversion circuit. Optionally, the controller 104 sends, to the display apparatus, the alarm information indicating that the leakage current fault occurs in the first power conversion circuit. For example, the controller 104 sends 3 to the display apparatus, where 3 indicates that the leakage current fault occurs in the first power conversion circuit. Alternatively, the controller 104 may send, to the cloud server, the alarm information indicating that the leakage current fault occurs in the first power conversion circuit, and the cloud server may mark and process a case in which the leakage current fault occurs in the first power conversion circuit.

S208b: The controller 104 controls the second connection switch unit 1023 to be turned on. In this case, the battery cluster control circuit 101, the first connection switch unit 1021, and the first power switch unit 1022 are in the on state, and the first detection circuit 103 detects that the leakage current of the energy storage system is less than or equal to the preset safety threshold. It may be considered that no leakage current fault occurs in the battery cluster 100, in the loop between the battery cluster control circuit 101 and the first power conversion circuit 102, and in the first power conversion circuit 102, and the controller 104 further controls the second connection switch unit 1023 to be turned on.

S209: The controller 104 determines whether the leakage current of the energy storage system detected by the first detection circuit 103 is greater than the preset safety threshold. In this case, the battery cluster control circuit 101, the first connection switch unit 1021, the first power switch unit 1022, and the second connection switch unit 1023 are in the on state. If the first detection circuit 103 detects that the leakage current of the energy storage system is greater than the preset safety threshold, the controller 104 performs step S210a. Otherwise, the controller 104 performs step S210b.

S210a: The controller 104 sends alarm information indicating that the leakage current fault occurs in a loop between the first power conversion circuit 102 and the power grid or the load. During specific implementation, because after performing step S208b, that is, the controller 104 eliminates a possibility that the leakage current fault occurs in the battery cluster 100, in the loop between the battery cluster control circuit 101 and the first power conversion circuit 102, and in the first power conversion circuit 102, the controller 104 further controls the second connection switch unit 1023 to be turned on. In this case, the first detection circuit 103 detects that the leakage current of the energy storage system is greater than the preset safety threshold, and it may be considered that the leakage current of the energy storage system is caused by the loop between the first power conversion circuit 102 and the power grid or the load. In other words, it is determined that the leakage current fault occurs in the loop between the first power conversion circuit 102 and the power grid or the load. For example, that the leakage current fault occurs in the loop between the first power conversion circuit 102 and the power grid or the load may be that the fault occurs in a cable connecting the first power conversion circuit 102 to the power grid or the load, or that the leakage current fault occurs in a contactor or a relay between the first power conversion circuit 102 and the power grid or the load. In this case, when determining that the leakage current fault occurs in the loop between the first power conversion circuit 102 and the power grid or the load, the controller 104 sends the alarm information indicating that the leakage current fault occurs in the loop between the first power conversion circuit and the power grid or the load. Optionally, the controller 104 sends, to the display apparatus, the alarm information indicating that the leakage current fault occurs in the loop between the first power conversion circuit and the power grid or the load. For example, the controller 104 sends 4 to the display apparatus, where 4 indicates that the leakage current fault occurs in the loop between the first power conversion circuit and the power grid or the load. Alternatively, the controller 104 may send, to the cloud server, the alarm information indicating that the leakage current fault occurs in the loop between the first power conversion circuit and the power grid or the load, and the cloud server may mark and process a case in which the leakage current fault occurs in the loop between the battery cluster control circuit and the first power conversion circuit.

S210b: The controller 104 determines that no leakage current fault occurs in the energy storage system. In this case, both the battery cluster control circuit 101 and the first power conversion circuit 102 are in the on state, and the first detection circuit 103 detects that the leakage current of the energy storage system is less than or equal to the preset safety threshold. It may be considered that the controller 104 performs step S201 due to a false alarm from the first detection circuit 103. When detecting, on the first detection circuit 103, that the leakage current of the energy storage system is less than or equal to the preset safety threshold, the controller determines that no leakage current fault occurs in the energy storage system, and restores normal running of the energy storage system. Optionally, the controller 104 may clear alarm information. Further, if the first detection circuit detects that the leakage current of the energy storage system is greater than the preset safety threshold for another time, the controller 104 continues to perform the fault location methods shown in FIG. 2 and FIG. 4, to check a location in which the leakage current fault occurs in the energy storage system.

In embodiments of this application, after the leakage current fault occurs in the energy storage system, after disconnecting the battery cluster control circuit from the first power conversion circuit, the controller sequentially enables the battery cluster control circuit, and the first connection switch unit, the first power switch unit, and the second connection switch unit that are in the first power conversion circuit to be connected and turned on. It may be determined, by checking the location that causes the leakage current fault in the energy storage system, that the fault occurs in the loop between the battery cluster control circuit and the first power conversion circuit, in the first power conversion circuit, or in the loop between the first power conversion circuit and the load or the power grid. Therefore, the leakage current fault in the energy storage system can be located. This facilitates the maintenance of the energy storage system, and has the high maintenance efficiency.

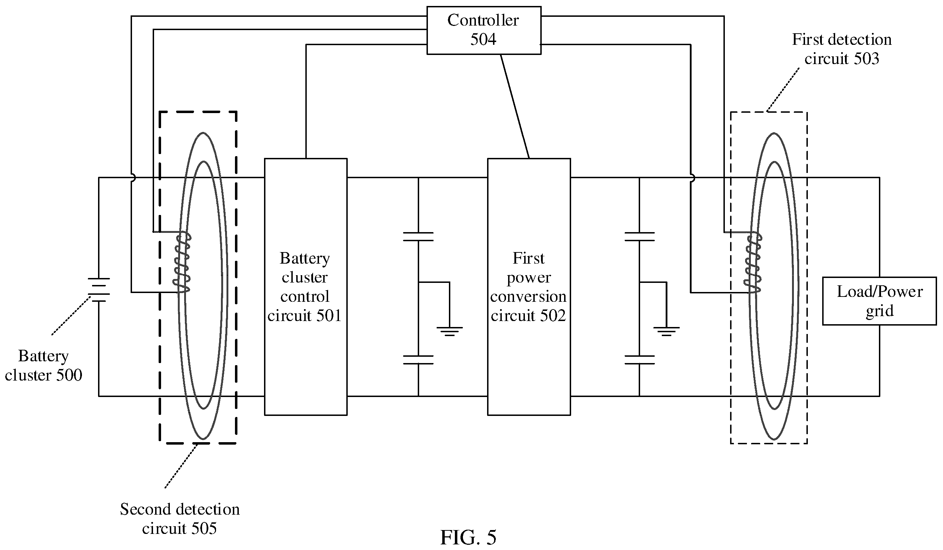

In some feasible implementations, the energy storage system further includes a second detection circuit, and the second detection circuit is disposed between the battery cluster and the battery cluster control circuit. In this case, a block diagram of a structure of the energy storage system is shown in FIG. 5. Refer to FIG. 5. The energy storage system includes a battery cluster 500, a battery cluster control circuit 501, a first power conversion circuit 502, a first detection circuit 503, a controller 504, and a second detection circuit 505.

The battery cluster 500 is connected to one end of the battery cluster control circuit 501, the other end of the battery cluster control circuit 501 is connected to one end of the first power conversion circuit 502, and the other end of the first power conversion circuit 502 is connected to a power grid or a load. The first detection circuit 503 is disposed between the first power conversion circuit 502 and the power grid or the load, and the second detection circuit 505 is disposed between the battery cluster 500 and the battery cluster control circuit 501.

The second detection circuit 505 is a leakage current protection apparatus of the battery cluster 500, and may be specifically implemented as an RCD. During specific implementation, when the second detection circuit 505 detects that a leakage current of the battery cluster 500 is greater than a battery safe current, the controller 504 may determine that a leakage current fault occurs in the battery cluster 500, and send alarm information indicating that the leakage current fault occurs in the battery cluster 500. Optionally, the controller 504 sends, to a display apparatus, the alarm information indicating that the leakage current fault occurs in the battery cluster 500. For example, the controller 504 sends 1 to the display apparatus, where 1 indicates that the leakage current fault occurs in the battery cluster 500. Further, the display apparatus displays 1, indicating that the leakage current fault occurs in the battery cluster 500. Alternatively, the controller 504 may send, to a cloud server, the alarm information indicating that the leakage current fault occurs in the battery cluster 500. The cloud server may mark and process the leakage current fault in the battery cluster 500.

For example, a value of the battery safe current may be preset, and the battery safe current is related to a type of the battery cluster 500 and a quantity of battery packs included in the battery cluster 500.

In embodiments of this application, in addition to performing embodiments described with reference to FIG. 2 to FIG. 4, the controller 504 may further determine, based on whether the leakage current of the battery cluster 500 detected by the second detection circuit 505 is greater than the battery safe current, whether the leakage current fault occurs in the battery cluster 500. For example, before controlling the battery cluster control circuit 501 to be connected, the controller 504 determines, based on whether the leakage current of the battery cluster 500 detected by the second detection circuit 505 is greater than the battery safe current, whether the leakage current fault occurs in the battery cluster 500. If the second detection circuit 505 detects that the leakage current of the battery cluster 500 is greater than the battery safe current, the controller 504 determines that the leakage current fault occurs in the battery cluster 500, and sends the alarm information indicating that the leakage current fault occurs in the battery cluster 500, so that fault response time can be shortened. If the second detection circuit 505 detects that the leakage current of the battery cluster 500 is less than or equal to the battery safe current, the controller 504 continues to control the battery cluster control circuit 501 to be turned on, and determines whether the leakage current of the energy storage system detected by the first detection circuit 503 is greater than a preset safety threshold. If the first detection circuit 503 detects that the leakage current of the energy storage system is greater than the preset safety threshold, the controller 504 determines that the leakage current fault occurs in the battery cluster 500. In other words, in embodiments of this application, double determining of the leakage current fault can be provided for the battery cluster, and safety is good.

Optionally, in some feasible implementations, when no leakage current fault occurs in the battery cluster 500, the controller 504 may update the preset safety threshold based on the leakage current of the battery cluster 500 detected by the second detection circuit 505. In this case, the second detection circuit 505 detects that the leakage current of the battery cluster 500 is less than or equal to the battery safe current. For example, the battery safe current is 1 A, and the preset safety threshold is 2.5 A. The second detection circuit 505 detects that the leakage current of the battery cluster is 0.1 A. In this case, 0.1 A is a normal leakage current of the battery cluster. The controller 504 may superimpose the normal leakage current of the battery cluster on the preset safety threshold, that is, update the preset safety threshold to 2.5 A+0.1 A=2.6 A.

In embodiments of this application, updating the preset safety threshold based on the normal leakage current of the battery cluster can reduce impact of the normal leakage current of the battery cluster on fault detection, improve leakage current detection precision of the energy storage system, and reduce a risk of a false alarm from the first detection circuit. System reliability is high.

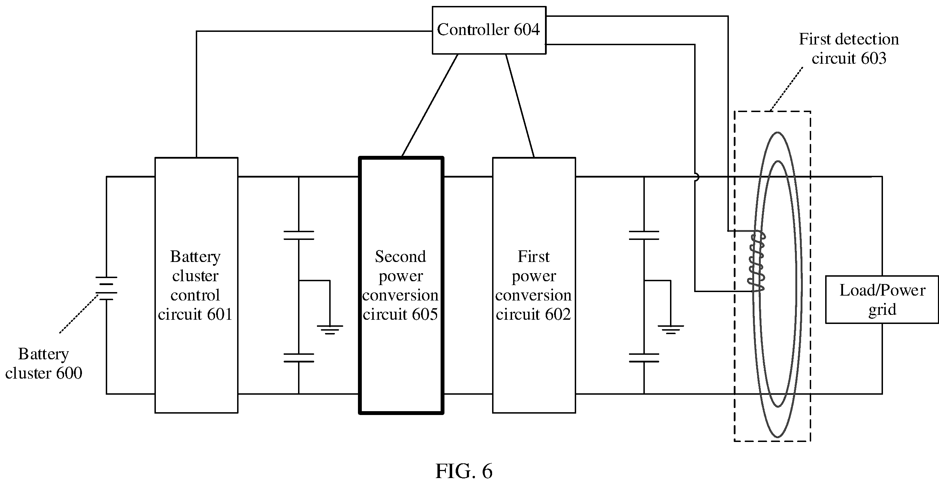

Optionally, in some feasible implementations, FIG. 6 is a block diagram of still another structure of an energy storage system according to an embodiment of this application. Refer to FIG. 6. The energy storage system includes a battery cluster 600, a battery cluster control circuit 601, a first power conversion circuit 602, a first detection circuit 603, a controller 604, and a second power conversion circuit 605.

The battery cluster 600 is connected to one end of the battery cluster control circuit 601, the other end of the battery cluster control circuit 601 is connected to one end of the second power conversion circuit 605, the other end of the second power conversion circuit 605 is connected to one end of the first power conversion circuit 602, and the other end of the first power conversion circuit 602 is connected to a power grid or a load. The first detection circuit 603 is disposed between the first power conversion circuit 602 and the power grid or the load. Different from the energy storage system shown in FIG. 1, the second power conversion circuit 605 is added to the energy storage system according to an embodiment of this application.

For example, the second power conversion circuit 605 may convert an input voltage or an output voltage of the battery cluster. The second power conversion circuit 605 may be specifically implemented as a DC/DC converter, an AC/DC converter, a DC/AC converter, or the like. Specific implementation of the second power conversion circuit 605 may be adjusted based on the first power conversion circuit.

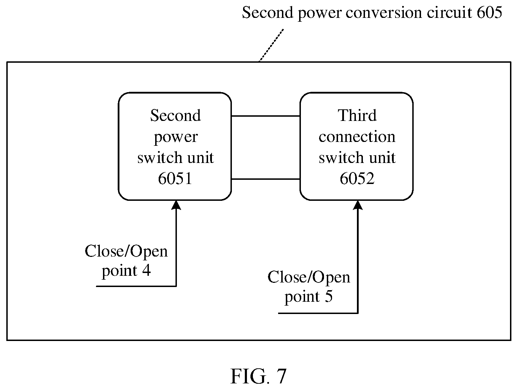

A block diagram of a structure of the second power conversion circuit 605 is shown in FIG. 7. The second power conversion circuit 605 includes a second power switch unit 6051 and a third connection switch unit 6052. One end of the second power switch unit 6051 is connected to the battery cluster control circuit 601, the other end of the second power switch unit 6051 is connected to one end of the third connection switch unit 6052, and the other end of the third connection switch unit 6052 is connected to the first power conversion circuit 602. It may be understood that the other end of the third connection switch unit 6052 is specifically connected to a first connection switch unit in the first power conversion circuit 602.

Optionally, at least one of the second power switch unit 6051 and the third connection switch unit 6052 may be a solid-state switch or a semiconductor switch.

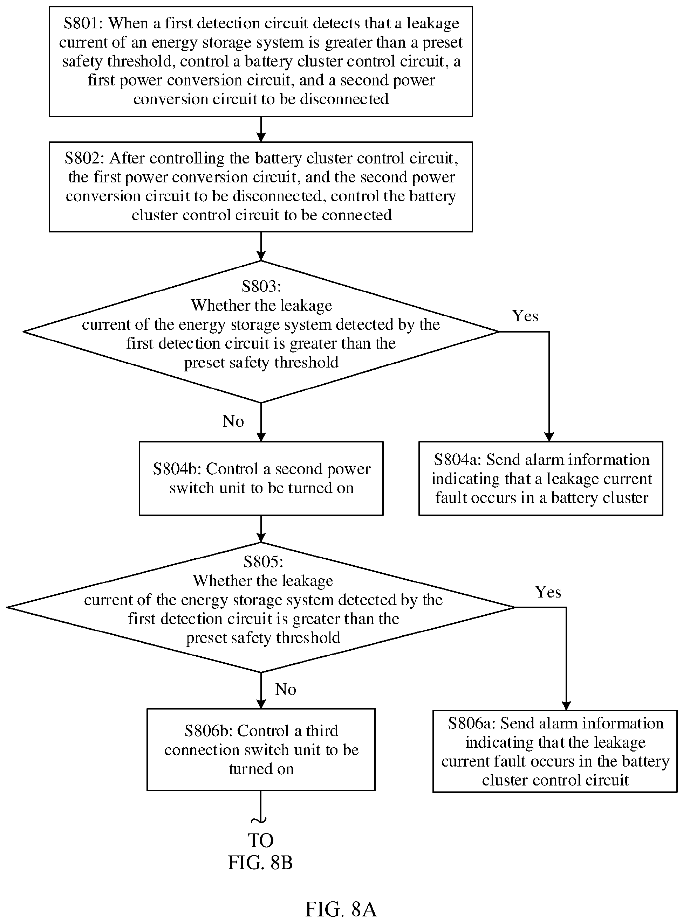

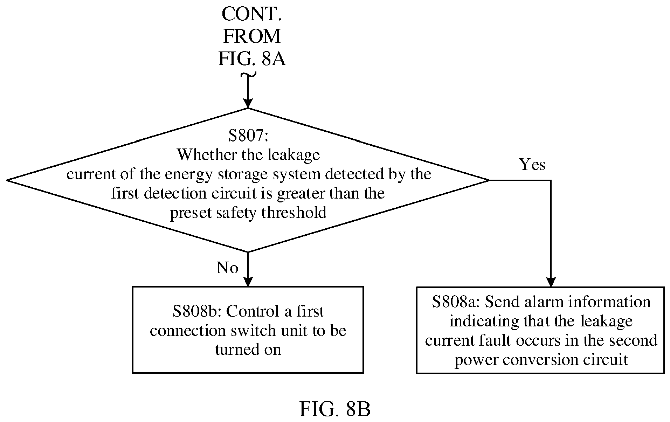

The controller 604 is connected to the battery cluster control circuit 601, the first power conversion circuit 602, the first detection circuit 603, and the second power conversion circuit 605. During specific implementation, the controller 604 may perform a leakage current fault location method shown in FIG. 8A and FIG. 8B, to locate a leakage location in the energy storage system. Specific execution steps are as follows.

S801: When the first detection circuit 603 detects that the leakage current of the energy storage system is greater than the preset safety threshold, the controller 604 controls the battery cluster control circuit 601, the first power conversion circuit 602, and the second power conversion circuit 605 to be disconnected. For example, the controller 604 controls the second power conversion circuit 605 to be disconnected, that is, to open a close/open point 4 and a close/open point 5. It may be understood that the close/open point 4 and the close/open point 5 may be considered as locations, of the switch units, that may be controlled by the controller 604. For example, the controller 604 opens the close/open point 4, that is, disconnects the second power switch unit 6051 from the battery cluster control circuit 601. The controller 604 opens the close/open point 5, that is, disconnects the second power switch unit 6051 from the third connection switch unit 6052.

Optionally, a structure of the first power conversion circuit 602 may be shown in FIG. 3. To be specific, disconnecting the first power conversion circuit 602 by the controller may be understood as opening the close/open point 1, the close/open point 2, and the close/open point 3.

S802: After controlling the battery cluster control circuit 601, the first power conversion circuit 602, and the second power conversion circuit 605 to be disconnected, the controller 604 controls the battery cluster control circuit 601 to be connected.

S803: The controller 604 determines whether the leakage current of the energy storage system detected by the first detection circuit 603 is greater than the preset safety threshold. In this case, the battery cluster control circuit 601 is connected. If the first detection circuit 603 detects that the leakage current of the energy storage system is greater than the preset safety threshold, the controller 604 performs step S804a. Otherwise, the controller 604 performs step S804b.

S804a: The controller 604 sends alarm information indicating that the leakage current fault occurs in the battery cluster 600. In this case, the battery cluster control circuit 601 is in an on state, and the first detection circuit 603 detects that the leakage current of the energy storage system is greater than the preset safety threshold. It may be considered that the leakage current of the energy storage system is caused by the battery cluster 600. The controller 604 determines that the leakage current fault occurs in the battery cluster 600, and sends the alarm information indicating that the leakage current fault occurs in the battery cluster 600. Optionally, the controller 504 sends, to a display apparatus, the alarm information indicating that the leakage current fault occurs in the battery cluster 500. For example, the controller 504 sends 1 to the display apparatus, where 1 indicates that the leakage current fault occurs in the battery cluster 600. Further, the display apparatus displays 1, indicating that the leakage current fault occurs in the battery cluster 600. Alternatively, the controller 604 may send, to a cloud server, the alarm information indicating that the leakage current fault occurs in the battery cluster 600. The cloud server may mark and process the leakage current fault in the battery cluster 600.

Optionally, in some feasible implementations, based on the energy storage system shown in FIG. 6, a second detection circuit (not shown in the figure) is disposed between the battery cluster 600 and the battery cluster control circuit 601. In other words, double determining of the leakage current fault may be provided for the battery cluster 600, and the preset safety threshold of the energy storage system shown in FIG. 6 may also be updated.

S804b: The controller 604 controls the second power switch unit to be turned on. In this case, the battery cluster control circuit 601 is in the on state, and the first detection circuit 603 detects that the leakage current of the energy storage system is less than or equal to the preset safety threshold. It may be considered that no leakage current fault occurs in the battery cluster 600, and the controller 604 further controls the second power switch unit 6051 to be turned on, that is, controls the close/open point 4 to be closed, and connects the battery cluster control circuit 601 to the second power switch unit 6051. In this case, the third connection switch unit 6052 and the first power conversion circuit 602 are still in an off state.

S805: The controller 604 determines whether the leakage current of the energy storage system detected by the first detection circuit 603 is greater than the preset safety threshold. In this case, the battery cluster control circuit 601 and the second power switch unit 6051 are in the on state. If the first detection circuit 603 detects that the leakage current of the energy storage system is greater than the preset safety threshold, the controller 604 performs step S806a. Otherwise, the controller 604 performs step S806b.

S806a: The controller 604 sends alarm information indicating that the leakage current fault occurs in the battery cluster control circuit 601. During specific implementation, because after performing step S804b, that is, the controller 604 eliminates a possibility that the leakage current fault occurs in the battery cluster 600, the controller 604 further controls the second power switch unit 6051 to be turned on. In this case, the first detection circuit 603 detects that the leakage current of the energy storage system is greater than the preset safety threshold, and it may be considered that the leakage current of the energy storage system is caused by the battery cluster control circuit 601. The controller 604 determines that the leakage current fault occurs in the battery cluster control circuit 601, and sends the alarm information indicating that the leakage current fault occurs in the battery cluster control circuit. For example, the controller 604 sends 5 to the display apparatus, where 5 indicates that the leakage current fault occurs in the battery cluster control circuit 601. Further, the display apparatus displays 5, indicating that the leakage current fault occurs in the battery cluster control circuit 601. Alternatively, the controller 104 may send, to a cloud server, the alarm information of the battery cluster control circuit 601. The cloud server may mark and process the leakage current fault in the battery cluster 100.

S806b: The controller 604 controls the third connection switch unit 6052 to be turned on. In this case, the battery cluster control circuit 601 and the first power switch unit 6051 are in the on state, and the first detection circuit 603 detects that the leakage current of the energy storage system is less than or equal to the preset safety threshold. It may be considered that no leakage current fault occurs in the battery cluster 600 and the battery cluster control circuit 601, and the controller 604 further controls the third connection switch unit 6052 to be turned on.

S807: The controller 604 determines whether the leakage current of the energy storage system detected by the first detection circuit 603 is greater than the preset safety threshold. In this case, the battery cluster control circuit 601, the second power switch unit 6051, and the third connection switch unit 6052 are in the on state. If the first detection circuit 603 detects that the leakage current of the energy storage system is greater than the preset safety threshold, the controller 604 performs step S808a. Otherwise, the controller 604 performs step S808b.

S808a: The controller 604 sends alarm information indicating that the leakage current fault occurs in the second power conversion circuit 605. During specific implementation, because after performing step S806b, that is, the controller 604 eliminates a possibility that the leakage current fault occurs in the battery cluster control circuit 601, the controller 604 further controls the third connection switch unit 6052 to be turned on. In this case, the first detection circuit 603 detects that the leakage current of the energy storage system is greater than the preset safety threshold, and it may be considered that the leakage current of the energy storage system is caused by the second power conversion circuit 605. The controller 604 determines that the leakage current fault occurs in the second power conversion circuit 605, and sends the alarm information indicating that the leakage current fault occurs in the second power conversion circuit. Optionally, the controller 604 sends, to the display apparatus, the alarm information indicating that the leakage current fault occurs in the second power conversion circuit. For example, the controller 604 sends 6 to the display apparatus, where 6 indicates that the leakage current fault occurs in the second power conversion circuit 605. Further, the display apparatus displays 6, indicating that the leakage current fault occurs in the second power conversion circuit 605. Alternatively, the controller 604 may send, to the cloud server, the alarm information indicating that the leakage current fault occurs in the second power conversion circuit 605, and the cloud server may mark and process a case in which the leakage current fault occurs in the second power conversion circuit 605.

S808b: The controller 604 controls a first connection switch unit to be turned on. In this case, the controller 604 may perform the fault location method shown in FIG. 4. Specific implementation may be performed with reference to the embodiment described in FIG. 4. Details are not described herein again.

In embodiments of this application, the second power conversion circuit is added between the battery cluster control circuit and the first power conversion circuit, to enhance adaptability of the energy storage system. The second power conversion circuit and the first power conversion circuit may perform two-stage conversion on the output voltage or the input voltage of the battery cluster. In this way, the energy storage system can be used in more scenarios. According to embodiments of this application, when the leakage current fault occurs in the energy storage system in which the second power conversion circuit is disposed, the leakage current fault in the energy storage system may be located.

It should be noted that, the terms "first" and "second" are used for descriptive purposes only, and cannot be construed as indicating or implying relative importance.

The foregoing description is merely a specific implementation of the present invention, but is not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. An energy storage system, wherein the energy storage system comprises a battery cluster, a battery cluster control circuit, a first power conversion circuit, a first detection circuit, and a controller, the battery cluster is connected to one end of the battery cluster control circuit, the other end of the battery cluster control circuit is connected to one end of the first power conversion circuit, the other end of the first power conversion circuit is configured to connect to a power grid or a load, and the first detection circuit is disposed between the first power conversion circuit and the power grid or the load;
the controller is configured to: when the first detection circuit detects that a leakage current of the energy storage system is greater than a preset safety threshold, control the battery cluster control circuit and the first power conversion circuit to be disconnected; and
the controller is further configured to: after controlling the battery cluster control circuit and the first power conversion circuit to be disconnected, control the battery cluster control circuit to be connected, and send, based on that the first detection circuit detects that the leakage current of the energy storage system is greater than the preset safety threshold, alarm information indicating that a leakage current fault occurs in the battery cluster.

2. The energy storage system according to claim 1, wherein the first power conversion circuit comprises a first connection switch unit, and the first connection switch unit is configured to connect to the battery cluster control circuit;
the controller is further configured to: when the battery cluster control circuit is connected, if the first detection circuit detects that the leakage current of the energy storage system is less than or equal to the preset safety threshold, control the first connection switch unit to be turned on; and
the controller is further configured to: when the first connection switch unit is turned on, send, based on that the first detection circuit detects that the leakage current of the energy storage system is greater than the preset safety threshold, alarm information indicating that the leakage current fault occurs in a loop between the battery cluster control circuit and the first power conversion circuit.

3. The energy storage system according to claim 2, wherein the first power conversion circuit further comprises a first power switch unit, and the first power switch unit is disposed between the first connection switch unit and the first detection circuit;
the controller is further configured to: when the first connection switch unit is turned on, if the first detection circuit detects that the leakage current of the energy storage system is less than or equal to the preset safety threshold, control the first power switch unit to be turned on; and
the controller is further configured to: when the first power switch unit is turned on, send, based on that the first detection circuit detects that the leakage current of the energy storage system is greater than the preset safety threshold, alarm information indicating that the leakage current fault occurs in the first power conversion circuit.

4. The energy storage system according to claim 2 or 3, wherein the first power conversion circuit further comprises a second connection switch unit, and the second connection switch unit is disposed between the first power switch unit and the first detection circuit;
the controller is further configured to: when the first power switch unit is turned on, if the first detection circuit detects that the leakage current of the energy storage system is less than or equal to the preset safety threshold, control the second connection switch unit to be turned on; and
the controller is further configured to: when the second connection switch unit is turned on, send, based on that the first detection circuit detects that the leakage current of the energy storage system is greater than the preset safety threshold, alarm information indicating that the leakage current fault occurs in a loop between the first power conversion circuit and the power grid or the load.

5. The energy storage system according to any one of claims 2 to 4, wherein the energy storage system further comprises a second power conversion circuit, and the second power conversion circuit is disposed between the battery cluster control circuit and the first connection switch unit;
the power conversion circuit comprises a second power switch unit, and the second power switch unit is configured to convert an input voltage or an output voltage of the battery cluster;
the controller is further configured to: when the battery cluster control circuit is connected, if the first detection circuit detects that the leakage current of the energy storage system is less than or equal to the preset safety threshold, before controlling the first connection switch unit to be turned on, control the second power switch unit to be turned on; and
the controller is further configured to: when the second power switch unit is turned on, send, based on that the first detection circuit detects that the leakage current of the energy storage system is greater than the preset safety threshold, alarm information indicating that the leakage current fault occurs in the battery cluster control circuit.

6. The energy storage system according to claim 5, wherein the second power conversion circuit further comprises a third connection switch unit, and the third connection switch unit is configured to connect to the first connection switch unit;
the controller is further configured to: when the second power switch unit is turned on, if the first detection circuit detects that the leakage current of the energy storage system is less than or equal to the preset safety threshold, control the third connection switch unit to be turned on; and
the controller is further configured to: when the third connection switch unit is turned on, send, based on that the first detection circuit detects that the leakage current of the energy storage system is greater than the preset safety threshold, alarm information indicating that the leakage current fault occurs in the second power conversion circuit.

7. The energy storage system according to any one of claims 1 to 6, wherein the energy storage system further comprises a second detection circuit, and the second detection circuit is disposed between the battery cluster and the battery cluster control circuit; and
the controller is further configured to: when the second detection circuit detects that the leakage current of the battery cluster is greater than a battery safe current, send alarm information indicating that the leakage current fault occurs in the battery cluster.

8. The energy storage system according to claim 7, wherein the controller is further configured to: when no leakage current fault occurs in the battery cluster, update the preset safety threshold based on the leakage current of the battery cluster detected by the second detection circuit.

9. A leakage current fault location method for an energy storage system, wherein the energy storage system comprises a battery cluster, a battery cluster control circuit, a first power conversion circuit, and a first detection circuit;
the battery cluster is connected to one end of the battery cluster control circuit, the other end of the battery cluster control circuit is connected to one end of the first power conversion circuit, the other end of the first power conversion circuit is configured to connect to a power grid or a load, and the first detection circuit is disposed between the first power conversion circuit and the power grid or the load; and
the leakage current fault location method comprises:
when the first detection circuit detects that a leakage current of the energy storage system is greater than a preset safety threshold, controlling the battery cluster control circuit and the first power conversion circuit to be disconnected; and
after controlling the battery cluster control circuit and the first power conversion circuit to be disconnected, controlling the battery cluster control circuit to be connected, and sending, based on that the first detection circuit detects that the leakage current of the energy storage system is greater than the preset safety threshold, alarm information indicating that a leakage current fault occurs in the battery cluster.

10. The leakage current fault location method according to claim 9, wherein the first power conversion circuit comprises a first connection switch unit, and the first connection switch unit is configured to connect to the battery cluster control circuit; and
the leakage current fault location method further comprises:
when controlling the battery cluster control circuit to be connected, if the first detection circuit detects that the leakage current of the energy storage system is less than or equal to the preset safety threshold, controlling the first connection switch unit to be turned on; and
when the first connection switch unit is turned on, sending, based on that the first detection circuit detects that the leakage current of the energy storage system is greater than the preset safety threshold, alarm information indicating that the leakage current fault occurs in a loop between the battery cluster and the first power conversion circuit.

11. The leakage current fault location method according to claim 10, wherein the first power conversion circuit further comprises a first power switch unit, and the first power switch unit is disposed between the first connection switch unit and the first detection circuit; and
the leakage current fault location method further comprises:
when the first connection switch unit is turned on, if the first detection circuit detects that the leakage current of the energy storage system is less than or equal to the preset safety threshold, controlling the first power switch unit to be turned on; and
when the first power switch unit is turned on, sending, based on that the first detection circuit detects that the leakage current of the energy storage system is greater than the preset safety threshold, alarm information indicating that the leakage current fault occurs in the first power conversion circuit.

12. The leakage current fault location method according to claim 10 or 11, wherein the first power conversion circuit further comprises a second connection switch unit, and the second connection switch unit is disposed between the first power switch unit and the first detection circuit; and
the leakage current fault location method further comprises:
when the first power switch unit is turned on, if the first detection circuit detects that the leakage current of the energy storage system is less than or equal to the preset safety threshold, controlling the second connection switch unit to be turned on; and
when the second connection switch unit is turned on, sending, based on that the first detection circuit detects that the leakage current of the energy storage system is greater than the preset safety threshold, alarm information indicating that the leakage current fault occurs in a loop between the first power conversion circuit and the power grid or the load.

13. The leakage current fault location method according to any one of claims 10 to 12, wherein the energy storage system further comprises a second power conversion circuit, and the second power conversion circuit is disposed between the battery cluster control circuit and the first connection switch unit;
the power conversion circuit further comprises a second power switch unit, and the second power switch unit is configured to convert an input voltage or an output voltage of the battery cluster; and
the leakage current fault location method further comprises:
when the battery cluster control circuit is connected, if the first detection circuit detects that the leakage current of the energy storage system is less than or equal to the preset safety threshold, before controlling the first connection switch unit to be turned on, controlling the second power switch unit to be turned on; and
when the second power switch unit is turned on, sending, based on that the first detection circuit detects that the leakage current of the energy storage system is greater than the preset safety threshold, alarm information indicating that the leakage current fault occurs in the battery cluster control circuit.

14. The leakage current fault location method according to claim 13, wherein the second power conversion circuit further comprises a third connection switch unit, and the third connection switch unit is configured to connect to the first connection switch unit; and
the leakage current fault location method further comprises:
when the second power switch unit is turned on, if the first detection circuit detects that the leakage current of the energy storage system is less than or equal to the preset safety threshold, controlling the third connection switch unit to be turned on; and
when the third connection switch unit is turned on, sending, based on that the first detection circuit detects that the leakage current of the energy storage system is greater than the preset safety threshold, alarm information indicating that the leakage current fault occurs in the second power conversion circuit.

15. The leakage current fault location method according to any one of claims 9 to 14, wherein the energy storage system further comprises a second detection circuit, and the second detection circuit is disposed between the battery cluster and the battery cluster control circuit; and
the leakage current fault location method further comprises:
when the second detection circuit detects that the leakage current of the battery cluster is greater than a battery safe current, sending alarm information indicating that the leakage current fault occurs in the battery cluster.

16. The leakage current fault location method according to claim 15, wherein the leakage current fault location method further comprises:
when no leakage current fault occurs in the battery cluster, updating the preset safety threshold based on the leakage current of the battery cluster detected by the second detection circuit.
